(19) Europäisches Patentamt / European Patent Office / Office européen des brevets

(11) **EP 3 255 442 B1**

(12) **FASCICULE DE BREVET EUROPEEN**

(45) Date de publication et mention de la délivrance du brevet:
**25.08.2021 Bulletin 2021/34**

(51) Int Cl.:
***G01R 31/00*** *(2006.01)*

(21) Numéro de dépôt: **17172066.7**

(22) Date de dépôt: **19.05.2017**

(54) **MÉTHODE DE DIAGNOSTIC D'UN ENSEMBLE DE BATTERIES D'ACCUMULATEURS RÉPARTIES DANS UNE FLOTTE DE VÉHICULES AUTOMOBILES**

DIAGNOSEMETHODE EINER ANORDNUNG VON AKKUBATTERIEN, DIE IN EINER FAHRZEUGFLOTTE VERTEILT SIND

METHOD FOR DIAGNOSING A SET OF ACCUMULATOR BATTERIES DISTRIBUTED IN A FLEET OF MOTOR VEHICLES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.06.2016 FR 1655169**

(43) Date de publication de la demande:
**13.12.2017 Bulletin 2017/50**

(73) Titulaire: **Renault s.a.s**
**92100 Boulogne-Billancourt (FR)**

(72) Inventeurs:
• **RICAUD, Anaïs**
**78280 GUYANCOURT (FR)**
• **PASCALY, Gwenaëlle**
**78000 VERSAILLES (FR)**
• **ORIGUCHI, Masato**
**78120 RAMBOUILLET (FR)**

(56) Documents cités:
GB-A- 2 473 956        US-A- 5 781 871
US-A1- 2015 046 106     US-A1- 2016 023 675

**Description**

DOMAINE TECHNIQUE AUQUEL SE RAPPORTE L'INVENTION

La présente invention concerne de manière générale l'alimentation en courant des moteurs électriques de traction de véhicules automobiles.

Elle concerne plus particulièrement une méthode de diagnostic d'un ensemble de batteries d'accumulateurs réparties dans une flotte de véhicules automobiles.

Elle concerne également un serveur distant adapté à communiquer avec une flotte de véhicules automobiles.

ARRIERE-PLAN TECHNOLOGIQUE

Les véhicules automobiles électriques et hybrides comportent tous un moteur électrique alimenté en courant par une batterie d'accumulateurs, communément appelée batterie de traction.

Une telle batterie de traction est généralement composée d'un grand nombre de petites cellules connectées ensemble en série et/ou en parallèle. Elle est en outre équipée d'un système électronique de gestion de l'énergie, qui permet de faire en sorte que les cellules se déchargent et se chargent toutes de la même manière, afin d'éviter des disparités de niveaux de charge, ce qui compromettrait fortement la durée de vie de la batterie de traction.

On constate malheureusement que dans certaines batteries de traction, il arrive qu'une (ou quelques) cellule(s) présente(nt) une défaillance généralement due à un défaut de fabrication (enveloppe de cellule non étanche, bornes mal connectées...), de sorte que cette (ou chacune de ces) cellule(s) perd progressivement sa capacité à se charger.

Dès lors, on observe une augmentation progressive des disparités de niveaux de charge des cellules au sein de la batterie de traction, jusqu'à un point tel où le système électronique de gestion de l'énergie est forcé de déclencher un processus d'arrêt complet du véhicule, afin d'éviter toute dégradation irréversible de la batterie de traction.

On connait ainsi du document KR100974765 une méthode permettant de détecter de telles disparités. Cette méthode consiste à calculer la moyenne des tensions aux bornes des cellules de la batterie de traction, puis à calculer l'écart entre cette moyenne et la tension aux bornes de chaque cellule. Alors, dès que l'un des écarts calculés dépasse un seuil, le système électronique de gestion de l'énergie commande l'arrêt complet du véhicule, ce qui provoque une panne immobilisante.

Une telle panne représente malheureusement un fort désagrément, puisque le véhicule doit alors être déplacé à l'aide d'une dépanneuse jusqu'à un atelier de réparation en mesure de traiter cette panne, ce qui prend du temps et est onéreux.

Le document US 5 781 871 divulgue un outil de diagnostic des batteries de servitude d'une flotte de véhicules thermiques, qui présente les mêmes inconvénients.

Le document US2015046106 A1 divulgue un système de diagnostic comprenant un serveur qui surveille les données de batterie reçues d'une flotte de véhicules.

OBJET DE L'INVENTION

Afin de remédier à l'inconvénient précité de l'état de la technique, la présente invention propose de suivre, par voie télématique, l'évolution des tensions aux bornes des cellules de nombreuses batteries de traction, afin de comparer le comportement de ces batteries et de détecter rapidement celles susceptibles de présenter prochainement une défaillance.

L'invention s'applique plus précisément aux véhicules automobiles électriques ou hybrides (comportant un moteur électrique de traction alimenté en courant par une batterie d'accumulateurs), qui comprennent un système de communication adapté à communiquer avec un serveur distant.

Plus particulièrement, on propose selon l'invention telle que définie par la revendication 1 une méthode de diagnostic d'un ensemble de batteries d'accumulateurs réparties dans une flotte de véhicules automobiles.

Ainsi, grâce à l'invention, en comparant la valeur du paramètre de diagnostic de chaque batterie avec la valeur de référence, il est possible d'anticiper une panne de l'une ou l'autre des batteries d'accumulateurs, ce qui permet de rappeler le véhicule automobile dans un atelier de réparation compétent avant que le problème ne provoque une panne immobilisante.

D'autres caractéristiques avantageuses et non limitatives de la méthode de diagnostic conforme à l'invention sont les suivantes :

- à l'étape d), une donnée fonction de la valeur de chaque paramètre de diagnostic de chaque batterie d'accumulateurs est comparée avec la valeur de référence calculée à l'étape c), et un premier diagnostic de la batterie d'accumulateurs est déduit en fonction du résultat de cette comparaison et d'un seuil prédéterminé ;

- chaque batterie d'accumulateurs comporte une pluralité de cellules et des moyens de mesure de la tension aux bornes de chaque cellule, le paramètre de diagnostic de la batterie d'accumulateurs est constitué par l'écart entre, d'une part, la tension qui est la plus grande parmi les tensions mesurées aux bornes des cellules, et, d'autre part, la tension qui est la plus petite parmi les tensions mesurées aux bornes des cellules ;

- chaque batterie d'accumulateurs comporte une pluralité de cellules et chaque véhicule automobile comportant des moyens de calcul de la capacité résiduelle de chaque cellule composant sa batterie d'accumulateurs, ledit paramètre de diagnostic de chaque batterie d'accumulateurs est constitué par l'écart entre, d'une part, la capacité résiduelle qui est la plus grande parmi les capacités résiduelles des cellules composant la batterie d'accumulateurs, et, d'autre part, la capacité résiduelle qui est la plus petite parmi les capacités résiduelles des cellules composant la batterie d'accumulateurs ;

- si, à l'étape d), le diagnostic établit une défaillance de la batterie d'accumulateurs de l'un des véhicules automobiles, une étape e) est réalisée au cours de laquelle le serveur distant transmet au système de communication dudit véhicule automobile un signal d'alerte ; et

- à l'étape a), seules les valeurs de paramètres de diagnostic associées à des batteries d'accumulateurs qui présentent des caractéristiques techniques de fabrication identiques sont prises en compte.

L'invention concerne également un serveur distant qui est adapté à communiquer avec des systèmes de communication équipant une flotte de véhicules automobiles, et qui comporte un calculateur adapté à mettre en œuvre un procédé de diagnostic tel que précisé.

DESCRIPTION DETAILLEE D'UN EXEMPLE DE REALISATION

La description qui va suivre en regard des dessins annexés, donnés à titre d'exemple non limitatif, fera bien comprendre en quoi consiste l'invention et comment elle peut être réalisée.

Sur les dessins annexés :

- la figure 1 est une vue schématique d'un serveur distant et d'une flotte de véhicules automobiles, et
- la figure 2 est un graphique illustrant la variation dans la durée d'un paramètre de diagnostic d'une batterie d'accumulateurs de l'un des véhicules automobiles de la figure 1.

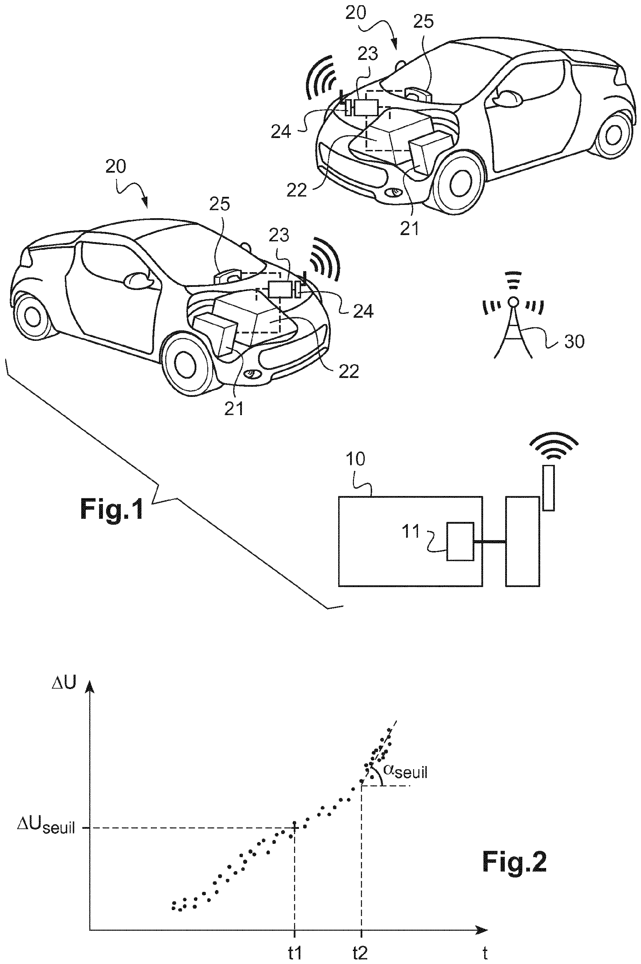

La figure 1 représente un exemple de contexte dans lequel peut être mise en œuvre l'invention.

Dans ce contexte, une flotte de plusieurs véhicules automobiles 20 est prévue pour communiquer avec un serveur distant 10.

Chaque véhicule automobile 20 comprend une batterie d'accumulateurs (ci-après appelée batterie de traction 21) et un moteur électrique 22 qui est alimenté en courant par la batterie de traction 21 et qui permet de faire avancer le véhicule automobile.

La batterie de traction 21 comporte une pluralité de cellules connectées ensemble de manière à ce que la batterie de traction 21 présente à ses bornes une tension élevée (ou « haute tension »).

La batterie de traction 21 embarque des moyens de mesure de la tension OCV aux bornes de chaque cellule. Cette tension OCV est convertible en un niveau de charge SOC, via une table de correspondance OCV/SOC propre à la chimie de la cellule. Chaque véhicule pourra ou non comporter en outre un moteur à combustion interne. Autrement formulé, la présente invention pourra aussi bien s'appliquer aux véhicules hybrides et hybrides rechargeables qu'aux véhicules électriques.

Chaque véhicule automobile 20 comprend par ailleurs une unité électronique de commande 23 qui est connectée, d'une part, à la batterie de traction 21, et, d'autre part, à un écran d'affichage 25 situé dans l'habitacle du véhicule.

Cette unité électronique de commande 23 est ainsi adaptée à acquérir les tensions OCV ou niveaux de charge SOC des cellules de la batterie de traction 21.

Elle est en outre prévue pour pouvoir entrer en communication via une liaison sans fil avec le serveur distant 10 afin d'échanger des données avec ce serveur distant 10, par exemple en vue d'un contrôle du bon fonctionnement de la batterie de traction 21.

Elle est à cet effet reliée à des moyens de communication 24 adaptés à se connecter à un réseau de téléphonie mobile 30. Classiquement ce réseau de téléphonie mobile 30 pourra comprendre une station en communication via une liaison radio avec le véhicule automobile 20 et une passerelle de connexion à un réseau public, par exemple le réseau Internet.

Le serveur distant 10 sera alors également connecté au réseau public de sorte que le véhicule automobile 20 et le serveur distant 10 puissent entrer en communication et échanger des données via le réseau de téléphonie mobile 30 et le réseau public.

L'unité électronique de commande 23 embarquée dans le véhicule automobile 10 comprend plus précisément un processeur et une unité de mémorisation, par exemple une mémoire non-volatile réinscriptible.

Cette mémoire stocke notamment des programmes d'ordinateur comprenant des instructions dont l'exécution par le processeur permet la mise en œuvre par l'unité électronique de commande 23 du procédé qui sera décrit ci-après.

Le serveur distant 10 comporte également une unité électronique, ci-après appelée calculateur 11, qui comprend un processeur et une unité de mémorisation, par exemple un disque dur.

Cette unité de mémorisation stocke aussi des programmes d'ordinateur comprenant des instructions dont l'exécution par le processeur permet la mise en œuvre par le calculateur 11 du procédé qui sera décrit ci-après.

Elle stocke également une base de données dans laquelle est mémorisée une pluralité d'enregistrements chacun associé à l'un des véhicules automobiles 20 de la flotte considérée.

Ici, chaque enregistrement de la base de données stockera plusieurs données, parmi lesquelles :

- un numéro d'identification attribué au véhicule automobile 20,
- une valeur d'un paramètre de diagnostic de la batterie de traction 21 embarquée dans ledit véhicule automobile 20, et
- un écart entre deux valeurs successives dudit paramètre de diagnostic.

Le calculateur 11 du serveur distant 10 et les unités électroniques de commande 23 des véhicules automobiles 20 de la flotte considérée sont alors conçus pour communiquer ensemble afin d'établir un diagnostic précis de l'état de fonctionnement des batteries de traction 21 de ces véhicules automobiles 20.

A ce stade, on pourra noter que la flotte de véhicules automobiles 20 considérée ne sera pas choisie aléatoirement. Au contraire, le critère sera que tous les véhicules soient équipés d'une même référence de batterie de traction 21. Ainsi, toutes les batteries de traction 21 diagnostiquées comporteront des caractéristiques techniques de fabrication identiques. Il sera ainsi possible de comparer leurs performances afin d'établir un diagnostic de ces batteries.

Selon une caractéristique particulièrement avantageuse de l'invention, la méthode de diagnostic mise en œuvre par le calculateur 11 du serveur distant 10 en lien avec les unités électroniques de commande 23 des véhicules automobiles 20 comporte quatre étapes principales, à savoir :

- une étape d'émission, par chaque véhicule automobile 20, de la valeur d'au moins un paramètre de diagnostic de la batterie d'accumulateurs 21,
- une étape de réception, par le serveur distant 10, des valeurs émises par tous les véhicules automobiles,
- une étape de calcul statistique d'une valeur de référence en fonction des valeurs reçues, et
- une étape de diagnostic de chacune des batteries d'accumulateurs 21, compte tenu des valeurs reçues et de la valeur de référence.

A la suite de ces quatre étapes, si le diagnostic établit une défaillance de la batterie d'accumulateurs 21 de l'un des véhicules automobiles 20, il est préférentiellement prévu une cinquième étape de transmission d'un signal d'alerte au véhicule automobile concerné, de manière que le conducteur de ce véhicule puisse prendre les mesures nécessaires.

On peut maintenant décrire plus en détail un mode particulier de mise en œuvre de cette méthode de diagnostic.

Dans ce mode de réalisation, le paramètre de diagnostic choisi, c'est-à-dire le paramètre qui va permettre de déterminer si les batteries d'accumulateurs 21 fonctionnent correctement ou non, est noté $\Delta U$. Il est ici choisi égal à l'écart entre :

- la tension $U_{max}$ qui est la tension la plus grande parmi les tensions mesurées aux bornes des cellules de la batterie d'accumulateurs 21 considérée, et
- la tension $U_{min}$ qui est la tension la plus petite parmi les tensions mesurées aux bornes de ces cellules.

On peut alors écrire :

$$\Delta U = U_{max} - U_{min}$$

On pourra alors prévoir que l'unité électronique de commande 23 de chaque véhicule automobile 20 calcule, à intervalles réguliers, la valeur $\Delta U_i$ de ce paramètre de diagnostic $\Delta U$. Cette valeur $\Delta U_i$, ainsi que le numéro d'identification du véhicule automobile 20, sont alors transmis par l'unité électronique de commande 23 du véhicule automobile 20 au calculateur 11 du serveur distant 10, via le réseau de téléphonie mobile 30 et le réseau public.

Selon une autre variante, on pourrait prévoir que l'unité électronique de commande 23 transmette au calculateur 11 du serveur distant 10 des données brutes (c'est-à-dire les valeurs des tensions mesurées aux bornes des cellules de la batterie d'accumulateurs 21, ou les valeurs minimale $U_{min}$ et maximale $U_{max}$ des tensions mesurées aux bornes des cellules de la batterie d'accumulateurs 21), et que le calculateur 11 se charge de déterminer la valeur $\Delta U_i$ de l'écart de tension maximum $\Delta U$. Dans cette variante, les paramètres de diagnostic seraient donc les valeurs minimale $U_{min}$ et maximale $U_{max}$ des tensions mesurées aux bornes des cellules de la batterie d'accumulateurs 21.

Quoi qu'il en soit, lorsqu'il obtient cette valeur $\Delta U_i$ et ce numéro d'identification, le calculateur 11 du serveur distant 10 met à jour sa base de données.

Pour cela, il recherche dans la base de données l'enregistrement correspondant au numéro d'identification reçu, il lit l'ancienne valeur $\Delta U_{i-1}$ stockée dans cet enregistrement (qu'il stocke dans sa mémoire vive), et il remplace cette ancienne valeur $\Delta U_{i-1}$ par la dernière valeur reçue $\Delta U_i$. Il calcule par ailleurs l'écart entre les deux dernières valeurs reçues $\Delta U_i$, $\Delta U_{i-1}$, noté $\alpha \Delta U_i$, avec

$$\alpha_{\Delta U_i} = \Delta U_i - \Delta U_{i-1}$$

Cet écart, qui représente la vitesse de variation du paramètre de diagnostic, est alors stocké dans l'enregistrement de la base de données.

En variante, on pourrait prévoir que le calculateur 11 conserve dans sa base de données les deux dernières valeurs reçues $\Delta U_i$, $\Delta U_{i-1}$ de chaque véhicule automobile 20, voire davantage de valeurs. Dans cette variante, l'écart $\alpha \Delta U_i$ pourra alors être calculé en fonction, non pas seulement des deux dernières valeurs reçues, mais d'un plus grand nombre de valeurs successivement reçues.

Une fois la base de données mise à jour, le calculateur 11 du serveur distant 10 peut alors mettre en œuvre, à intervalles réguliers, deux diagnostics préliminaires.

Le premier diagnostic préliminaire consiste ici à comparer la dernière valeur reçue $\Delta U_i$ du paramètre de diagnostic $\Delta U$ de chaque batterie d'accumulateurs 21 avec un seuil $\Delta U_{seuil}$ déterminé.

Ce seuil $\Delta U_{seuil}$ sera ici calculé en fonction de la valeur de référence $\Delta U_{ref}$ précitée (dont on rappelle qu'elle est obtenue par un calcul statistique fonction de l'ensemble des valeurs reçues $\Delta U_i$).

En pratique, la valeur de référence $\Delta U_{ref}$ peut être choisie égale à la moyenne arithmétique des valeurs $\Delta U_i$ mémorisées dans l'ensemble des enregistrements de la base de données.

Alors, le seuil $\Delta U_{seuil}$ pourra par exemple être choisi égal à la valeur de référence $\Delta U_{ref}$, multipliée par un coefficient prédéterminé (par exemple 1,25).

Sur la figure 2, on a représenté l'évolution au cours du temps des valeurs $\Delta U_i$ du paramètre de diagnostic $\Delta U$, pour une batterie de traction 21 dans laquelle l'une des cellules présente un dysfonctionnement. On y observe que ces valeurs augmentent progressivement au cours du temps. En d'autres termes, la disparité entre les charges des différentes cellules de la batterie croît progressivement, ce qui indique un problème.

Grâce au premier diagnostic préliminaire, il est possible d'établir une suspicion de dysfonctionnement, à l'instant t1 où il est détecté que la valeur $\Delta U_i$ du paramètre de diagnostic $\Delta U$ dépasse le seuil $\Delta U_{seuil}$.

Le second diagnostic préliminaire consiste ici à comparer la variation des valeurs reçues (en pratique l'écart $\alpha_{\Delta Ui}$) pour chaque batterie d'accumulateurs 21 avec un seuil $\alpha_{seuil}$ déterminé.

Ce seuil $\alpha_{seuil}$ sera ici calculé en fonction de la valeur de référence $\alpha_{ref}$ précitée (dont on rappelle qu'elle est obtenue par un calcul statistique fonction des valeurs reçues $\Delta U_i$).

En pratique, la valeur de référence $\alpha_{ref}$ peut être choisie égale à la moyenne arithmétique des écarts $\alpha_{ref}$ mémorisées dans l'ensemble des enregistrements de la base de données.

Alors, le seuil $\alpha_{seuil}$ pourra par exemple être égal à la valeur de référence $\alpha_{ref}$, multipliée par un coefficient prédéterminé (par exemple 1,1).

Comme le montre la figure 2, grâce au second diagnostic préliminaire, il est possible d'établir une suspicion de dysfonctionnement, à l'instant t2 où il est détecté que l'écart $\alpha_{\Delta Ui}$ dépasse le seuil $\alpha_{seuil}$.

Dans le mode de réalisation ici considéré, le calculateur 11 considère alors que la batterie de traction 21 est défaillante lorsque les premier et second diagnostics indiquent simultanément une défaillance de la batterie de traction 21 (ici à l'instant t2).

Dès lors, différentes solutions peuvent être mises en œuvre.

La première solution est que, lorsque le véhicule concerné est amené pour son entretien dans un atelier ayant accès à la base de données, le réparateur puisse relever cette défaillance et changer ou réparer la batterie de traction 21.

Une autre solution est que le calculateur 11 transmette à l'unité électronique de commande 23 du véhicule automobile 20 concerné un signal d'alerte, de manière que ce dernier affiche sur l'écran d'affichage 25 une alerte préliminaire demandant au conducteur d'aller faire réviser la batterie de traction 21 dans un délai proche.

On notera que cette alerte interviendra avant que le système de gestion de l'énergie de la batterie de traction ne détecte un problème et qu'il immobilise le véhicule automobile.

La présente invention n'est nullement limitée au mode de réalisation décrit et représenté. L'invention n'est limitée que par les revendications.

En particulier, on pourra prévoir d'utiliser un paramètre de diagnostic différent du paramètre $\Delta U$. Ainsi, on pourra utiliser un paramètre de diagnostic $\Delta SOC$ égal à la différence entre le niveau de charge $SOC_{max}$ de la cellule la plus chargée et le niveau de charge $SOC_{min}$ de la cellule la moins chargée de la batterie de traction. Le procédé de diagnostic sera alors sensiblement le même que celui exposé supra.

Selon une autre variante, on pourrait aussi considérer deux paramètres de diagnostic en combinaison, par exemple le paramètre $\Delta U$ et le paramètre $\Delta SOC$. Dans cette variante, on pourra alors par exemple établir quatre diagnostics préliminaires, puis émettre un signal d'alerte lorsque ces quatre diagnostics indiquent simultanément que la batterie de traction correspondante est défaillante.

Selon une autre variante non couverte par l'invention revendiquée, on pourrait établir le diagnostic de chaque batterie d'accumulateurs en n'utilisant que l'un ou l'autre des diagnostics préliminaires décrits supra.

## Revendications

1. Méthode de diagnostic d'un ensemble de batteries d'accumulateurs (21) réparties dans une flotte de véhicules automobiles (20), lesdits véhicules automobiles (20) comportant chacun un moteur électrique de traction (22) alimenté en courant par l'une desdites batteries d'accumulateurs et un système de communication (24) adapté à communiquer avec un serveur distant (10), **caractérisée en ce qu'**elle comporte :

a) une étape d'émission, par le système de communication (24) de chaque véhicule automobile, d'au moins une valeur ($\Delta U_i$, $\Delta U_{i-1}$) d'au moins un paramètre de diagnostic ($\Delta U$) de la batterie d'accumulateurs (21) associée audit véhicule automobile (20),

b) une étape de réception, par le serveur distant (10), des valeurs ($\Delta U_i$, $\Delta U_{i-1}$) émises à l'étape a),
c) une étape de calcul statistique d'une valeur de référence ($\Delta U_{ref}$, $\alpha_{ref}$), en fonction des valeurs ($\Delta U_i$, $\Delta U_{i-1}$) reçues à l'étape b),
d) une étape de diagnostic des batteries d'accumulateurs (21), compte tenu des valeurs ($\Delta U_i$, $\Delta U_{i-1}$) reçues à l'étape b) et de la valeur de référence ($\Delta U_{ref}$, $\alpha_{ref}$) calculée à l'étape c),

la méthode étant **caractérisée en ce que** :

- à l'étape a), le système de communication (24) de chaque véhicule automobile émet deux valeurs ($\Delta U_i$, $\Delta U_{i-1}$) successives de chaque paramètre de diagnostic ($\Delta U$) de la batterie d'accumulateurs (21) associée audit véhicule automobile (20),
- à l'étape b), les valeurs ($\Delta U_i$, $\Delta U_{i-1}$) successives émises à l'étape a) sont reçues,
- à l'étape c), ladite valeur de référence ($\alpha_{ref}$) est calculée en fonction des écarts entre les valeurs ($\Delta U_i$, $\Delta U_{i-1}$) successives de chaque paramètre de diagnostic ($\Delta U$) de chaque batterie d'accumulateurs (21), et
- à l'étape d), une donnée relative aux écarts entre les deux valeurs ($\Delta U_i$, $\Delta U_{i-1}$) successives de chaque paramètre de diagnostic ($\Delta U$) de chaque batterie d'accumulateurs (21) est comparée avec la valeur de référence ($\alpha_{ref}$) calculée à l'étape c), et un second diagnostic de chaque batterie d'accumulateurs (20) est déduit en fonction du résultat de cette comparaison, une batterie d'accumulateurs (20) étant considérée défaillante si les premier et second diagnostics indiquent une défaillance de la batterie d'accumulateurs.

2. Méthode de diagnostic selon la revendication précédente, dans laquelle à l'étape d), une donnée ($\Delta U_i$) fonction de la valeur ($\Delta U_i$) de chaque paramètre de diagnostic ($\Delta U$) de chaque batterie d'accumulateurs (21) est comparée avec la valeur de référence ($\Delta U_{ref}$) calculée à l'étape c), et un premier diagnostic de la batterie d'accumulateurs (21) est déduit en fonction du résultat de cette comparaison et d'un seuil prédéterminé.

3. Méthode de diagnostic selon l'une des revendications précédentes, dans laquelle, chaque batterie d'accumulateurs (21) comportant une pluralité de cellules et des moyens de mesure de la tension aux bornes de chaque cellule, le paramètre de diagnostic ($\Delta U$) de la batterie d'accumulateurs (21) est constitué par l'écart entre, d'une part, la tension qui est la plus grande parmi les tensions mesurées aux bornes des cellules, et, d'autre part, la tension qui est la plus petite parmi les tensions mesurées aux bornes des cellules.

4. Méthode de diagnostic selon l'une des revendications précédentes, dans laquelle, chaque batterie d'accumulateurs (21) comportant une pluralité de cellules et chaque véhicule automobile (20) comportant des moyens de calcul de la capacité résiduelle (SOC) de chaque cellule composant sa batterie d'accumulateurs (21), ledit paramètre de diagnostic de chaque batterie d'accumulateurs (21) est constitué par l'écart entre, d'une part, la capacité résiduelle qui est la plus grande parmi les capacités résiduelles des cellules composant la batterie d'accumulateurs (21), et, d'autre part, la capacité résiduelle qui est la plus petite parmi les capacités résiduelles des cellules composant la batterie d'accumulateurs (21).

5. Méthode de diagnostic selon l'une des revendications précédentes, dans laquelle si, à l'étape d), le diagnostic établit une défaillance de la batterie d'accumulateurs (21) de l'un des véhicules automobiles (20), une étape e) est réalisée au cours de laquelle le serveur distant (10) transmet au système de communication (24) dudit véhicule automobile (20) un signal d'alerte.

6. Méthode de diagnostic selon l'une des revendications précédentes, dans laquelle à l'étape a), seules les valeurs ($\Delta U_i$, $\Delta U_{i-1}$) de paramètres de diagnostic ($\Delta U$) associées à des batteries d'accumulateurs (21) qui présentent des caractéristiques techniques de fabrication identiques sont prises en compte.

7. Serveur distant (10) adapté à communiquer avec des systèmes de communication (24) équipant une flotte de véhicules automobiles (20), **caractérisé en ce qu'**il comporte un calculateur (11) adapté à mettre en œuvre un procédé de diagnostic conforme à l'une des revendications précédentes.

**Patentansprüche**

1. Verfahren zur Diagnose einer Anordnung von Akkumulatorbatterien (21), die in einer Kraftfahrzeugflotte (20) verteilt sind, wobei die Kraftfahrzeuge (20) jeweils einen elektrischen Antriebsmotor (22), der von einer der Akkumulatorbatterien mit Strom versorgt wird, und ein Kommunikationssystem (24), das geeignet ist, mit einem Remote-Server (10) zu kommunizieren, aufweisen, **dadurch gekennzeichnet, dass** es Folgendes aufweist:

a) einen Schritt des Sendens, vom Kommunikationssystem (24) jedes Kraftfahrzeugs, mindestens eines Werts ($\Delta U_i$, $\Delta U_{i-1}$) mindestens eines Diagnoseparameters ($\Delta U$) der Akkumulatorbatterie (21), die dem Kraftfahrzeug (20) zugeordnet ist,

b) einen Schritt des Empfangens, vom Remote-Server (10), der Werte ($\Delta U_i$, $\Delta U_{i-1}$), die bei Schritt a) gesendet werden,

c) einen Schritt des statistischen Berechnens eines Referenzwerts ($\Delta U_{ref}$, $\alpha_{ref}$) in Abhängigkeit von den Werten ($\Delta U_i$, $\Delta U_{i-1}$), die bei Schritt b) empfangen werden,

d) einen Schritt des Diagnostizierens der Akkumulatorbatterien (21) unter Berücksichtigung der Werte ($\Delta U_i$, $\Delta U_{i-1}$), die bei Schritt b) empfangen werden, und des Referenzwerts ($\Delta U_{ref}$, $\alpha_{ref}$), der bei Schritt c) berechnet wird,

wobei das Verfahren **dadurch gekennzeichnet ist, dass**:

- bei Schritt a) das Kommunikationssystem (24) jedes Kraftfahrzeugs zwei aufeinanderfolgende Werte ($\Delta U_i$, $\Delta U_{i-1}$) jedes Diagnoseparameters ($\Delta U$) der Akkumulatorbatterie (21) sendet, die dem Kraftfahrzeug (20) zugeordnet ist,

- bei Schritt b) die aufeinanderfolgenden Werte ($\Delta U_i$, $\Delta U_{i-1}$) empfangen werden, die bei Schritt a) gesendet werden,

- bei Schritt c) der Referenzwert ($\alpha_{ref}$) in Abhängigkeit von den Abweichungen zwischen den aufeinanderfolgenden Werten ($\Delta U_i$, $\Delta U_{i-1}$) jedes Diagnoseparameters ($\Delta U$) jeder Akkumulatorbatterie (21) berechnet wird, und

- bei Schritt d) ein Datenelement in Bezug auf die Abweichungen zwischen den zwei aufeinanderfolgenden Werten ($\Delta U_i$, $\Delta U_{i-1}$) jedes Diagnoseparameters ($\Delta U$) jeder Akkumulatorbatterie (21) mit dem Referenzwert ($\alpha_{ref}$) verglichen wird, der bei Schritt c) berechnet wird, und eine zweite Diagnose jeder Akkumulatorbatterie (20) in Abhängigkeit vom Ergebnis dieses Vergleichs abgeleitet wird, wobei eine Akkumulatorbatterie (20) als fehlerhaft angesehen wird, wenn die erste und zweite Diagnose auf einen Fehler der Akkumulatorbatterie hinweisen.

2. Diagnoseverfahren nach dem vorhergehenden Anspruch, wobei bei Schritt d) ein Datenelement ($\Delta U_i$), das vom Wert ($\Delta U_i$) jedes Diagnoseparameters ($\Delta U$) jeder Akkumulatorbatterie (21) abhängig ist, mit dem Referenzwert ($\Delta U_{ref}$) verglichen wird, der bei Schritt c) berechnet wird, und eine erste Diagnose der Akkumulatorbatterie (21) in Abhängigkeit vom Ergebnis dieses Vergleichs und einer vorbestimmten Schwelle abgeleitet wird.

3. Diagnoseverfahren nach einem der vorhergehenden Ansprüche, wobei, jede Akkumulatorbatterie (21) aufweisend eine Mehrzahl von Zellen und Mittel zur Messung der Spannung an den Anschlüssen jeder Zelle, der Diagnoseparameter ($\Delta U$) der Akkumulatorbatterie (21) von der Abweichung zwischen einerseits der Spannung, welche die größte von den Spannungen ist, die an den Anschlüssen der Zellen gemessen werden, und andererseits der Spannung, welche die kleinste von den Spannungen ist, die an den Anschlüssen der Zellen gemessen werden, gebildet ist.

4. Diagnoseverfahren nach einem der vorhergehenden Ansprüche, wobei, jede Akkumulatorbatterie (21) aufweisend eine Mehrzahl von Zellen und jedes Kraftfahrzeug (20) aufweisend Mittel zur Berechnung der Restkapazität (SOC) jeder Zelle, die ihre Akkumulatorbatterie (21) bildet, der Diagnoseparameter jeder Akkumulatorbatterie (21) von der Abweichung zwischen einerseits der Restkapazität, welche die größte von den Restkapazitäten der Zellen ist, die die Akkumulatorbatterie (21) bilden, und andererseits der Restkapazität, die die kleinste von den Restkapazitäten der Zellen ist, die die Akkumulatorbatterie (21) bilden, gebildet ist.

5. Diagnoseverfahren nach einem der vorhergehenden Ansprüche, wobei, wenn bei Schritt d) die Diagnose einen Fehler der Akkumulatorbatterie (21) eines der Kraftfahrzeuge (20) ergibt, ein Schritt e) durchgeführt wird, im Verlauf dessen der Remote-Server (10) ein Warnsignal an das Kommunikationssystem (24) des Kraftfahrzeugs (20) überträgt.

6. Diagnoseverfahren nach einem der vorhergehenden Ansprüche, wobei bei Schritt a) nur die Werte ($\Delta U_i$, $\Delta U_{i-1}$) von Diagnoseparametern ($\Delta U$), die Akkumulatorbatterien (21) zugeordnet sind, die identische technische Fertigungsmerkmale aufweisen, berücksichtigt werden.

7. Remote-Server (10), der geeignet ist, mit Kommunikationssystemen (24) zu kommunizieren, mit denen eine Kraftfahrzeugflotte (20) ausgestattet ist, **dadurch gekennzeichnet, dass** er einen Rechner (11) aufweist, der geeignet ist, ein Diagnoseverfahren nach einem der vorhergehenden Ansprüche durchzuführen.

**Claims**

1. Method for diagnosing a set of accumulator batteries (21) distributed in a fleet of motor vehicles (20), said motor vehicles (20) each comprising an electric traction motor (22) supplied with current by one of said accumulator batteries and a communication system (24) designed to communicate with a remote server (10), **characterized in that** it comprises:

a) a step of transmission, by the communication system (24) of each motor vehicle, of at least

one value ($\Delta U_i$, $\Delta U_{i-1}$) of at least one diagnostic parameter ($\Delta U$) of the accumulator battery (21) associated with said motor vehicle (20),
b) a step of reception, by the remote server (10), of the values ($\Delta U_i$, $\Delta U_{i-1}$) transmitted in step a) ;
c) a step of statistical calculation of a reference value ($\Delta U_{ref}$, $\alpha_{ref}$), on the basis of the values ($\Delta U_i$, $\Delta U_{i-1}$) received in step b),
d) a step of diagnosing the accumulator batteries (21), taking into account the values ($\Delta U_i$, $\Delta U_{i-1}$) received in step b) and the reference value ($\Delta U_{ref}$, $\alpha_{ref}$) calculated in step c),

the method being **characterized in that**:

- in step a), the communication system (24) of each motor vehicle transmits two successive values ($\Delta U_i$, $\Delta U_{i-1}$) of each diagnostic parameter ($\Delta U$) of the accumulator battery (21) associated with said motor vehicle (20),
- in step b), the successive values ($\Delta U_i$, $\Delta U_{i-1}$) transmitted in step a) are received,
- in step c), said reference value ($\alpha_{ref}$) is calculated on the basis of the differences between the successive values ($\Delta U_i$, $\Delta U_{i-1}$) of each diagnostic parameter ($\Delta U$) of each accumulator battery (21), and
- in step d), an item of data relating to the differences between the two successive values ($\Delta U_i$, $\Delta U_{i-1}$) of each diagnostic parameter ($\Delta U$) of each accumulator battery (21) is compared with the reference value ($\alpha_{ref}$) calculated in step c), and a second diagnosis of each accumulator battery (20) is deduced on the basis of the result of this comparison, an accumulator battery (20) being considered to be faulty if the first and second diagnoses indicate a fault with the accumulator battery.

2. Diagnostic method according to the preceding claim, wherein, in step d), an item of data ($\Delta U_i$) dependent on the value ($\Delta U_i$) of each diagnostic parameter ($\Delta U$) of each accumulator battery (21) is compared with the reference value ($\Delta U_{ref}$) calculated in step c), and a first diagnosis of the accumulator battery (21) is deduced on the basis of the result of this comparison and of a predetermined threshold.

3. Diagnostic method according to either of the preceding claims, wherein, with each accumulator battery (21) comprising a plurality of cells and means for measuring the voltage across the terminals of each cell, the diagnostic parameter ($\Delta U$) of the accumulator battery (21) consists of the difference between firstly the highest voltage from among the voltages measured across the terminals of the cells, and secondly the lowest voltage from among the voltages measured across the terminals of the cells.

4. Diagnostic method according to one of the preceding claims, wherein, with each accumulator battery (21) comprising a plurality of cells and each motor vehicle (20) comprising means for calculating the residual capacity (SOC) of each cell forming its accumulator battery (21), said diagnostic parameter of each accumulator battery (21) consists of the difference between firstly the highest residual capacity from among the residual capacities of the cells forming the accumulator battery (21), and secondly the lowest residual capacity from among the residual capacities of the cells forming the accumulator battery (21).

5. Diagnostic method according to one of the preceding claims, wherein if, in step d), the diagnosis identifies a fault with the accumulator battery (21) of one of the motor vehicles (20), a step e) is performed in which the remote server (10) transmits an alert signal to the communication system (24) of said motor vehicle (20).

6. Diagnostic method according to one of the preceding claims, wherein, in step a), only the values ($\Delta U_i$, $\Delta U_{i-1}$) of diagnostic parameters ($\Delta U$) associated with accumulator batteries (21) that have identical technical production features are taken into account.

7. Remote server (10) designed to communicate with communication systems (24) fitted to a fleet of motor vehicles (20), **characterized in that** it comprises a computer (11) designed to implement a diagnostic method according to one of the preceding claims.

**Fig.1**

**Fig.2**

**EP 3 255 442 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- KR 100974765
- US 5781871 A
- US 2015046106 A1